# EUROPÄISCHE PATENTSCHRIFT

(11) **EP 1 504 519 B1**
(45) Veröffentlichungstag und Bekanntmachung des Hinweises auf die Patenterteilung: **30.06.2010**
(21) Anmeldenummer: 03729868.4
(22) Anmeldetag: 07.05.2003
(51) Int. Cl.: H02N 2/18, H01L 41/113

(54) **VORRICHTUNG ZUR UMWANDLUNG MECHANISCHER ENERGIE IN ELEKTRISCHE ENERGIE**
DEVICE FOR CONVERTING MECHANICAL ENERGY INTO ELECTRICAL ENERGY
DISPOSITIF POUR TRANSFORMER UNE ENERGIE MECANIQUE EN ENERGIE ELECTRIQUE

(30) Priorität: 14.05.2002 DE 10221420
(43) Veröffentlichungstag der Anmeldung: 09.02.2005
(73) Patentinhaber: EnOcean GmbH, 82041 Oberhaching (DE)
(72) Erfinder: SCHMIDT, Frank, 85604 Zorneding (DE)
(74) Vertreter: Epping - Hermann - Fischer
(86) Internationale Anmeldenummer: PCT/DE2003/001468
(87) Internationale Veröffentlichungsnummer: WO 2003/096521

(56) Entgegenhaltungen:
- WO-A-01/35470
- WO-A-02/29965
- DE-A- 19 601 917
- PATENT ABSTRACTS OF JAPAN vol. 1999, no. 10, 31. August 1999 (1999-08-31) & JP 11 146663 A (SONY CORP), 28. Mai 1999 (1999-05-28) -& JP 11 146663 A (SONY CORP) 28. Mai 1999 (1999-05-28)

## Beschreibung

Die Erfindung betrifft eine Vorrichtung zum Wandeln mechanischer Energie in elektrische Energie mit einem Piezowandler, an welchem bei seiner Verformung eine elektrische Spannung gebildet wird.

Bei einer aus der WO 98/36395 bekannten Vorrichtung wird durch mechanische Deformation eines Piezowandlers eine elektrische Spannung, welche aus Ladungsverschiebungen im piezoelektrischen Material des Wandlers resultiert, erzeugt.

Die bekannte Vorrichtung beinhaltet einen prozessenergienutzenden drahtlosen Funkschalter, welcher einen piezoelektrischen Wandler aufweist, der mit Fingerdruck beaufschlagbar ist und eine elektrische Spannung erzeugt. Dem vom Schalter erzeugten Hochfrequenzsignal kann Identnummer und eine Sensorinformation aufgeprägt sein. In dieser Erfindung wird die Umwandlung von mechanischer in elektrische Energie jeweils durch eine einmalige mechanische Verformung des Piezoelektrischen Wandlers gewonnen, indem eine mechanische Betätigungsvorrichtung mit Übertotpunkt-Feder verwendet wird, die bei einer Belastung über den Totpunkt hinaus schlagartig mit der eingestellten mechanischen Vorspannung auf den Wandler einwirkt.

Aus der WO 02/29965 A ist eine Vorrichtung zur Umwandlung mechanischer Energie in elektrische Energie bekannt, die ein elektrovolumetrisches Wandlerelement, eine schwingungsfähige Masse und mindestens ein Übertragungselement zur Übertragung von Schwingungen aufweist. Dabei ist das Wandlerelement so am Übertragungselement befestigt, dass eine Schwingung der Masse mindestens teilweise in eine Volumenänderung des Wandlerelementes unter Erzeugung einer elektrischen Spannung übertragbar ist. Eine gute Energieausnutzung ist bei der bekannten Anordnung dadurch gewährleistet, dass zwei gegenüberliegende Wandlerelemente vorgesehen sind, so dass es unerheblich ist, in welcher der beiden möglichen Richtung die Schwingung erfolgt.

Ausgehend von der bekannten Anordnung liegt der Erfindung die Aufgabe zugrunde, dass eine kostengünstigere Vorrichtung bereitzustellen ist, bei der sowohl einzelne Schwingungs- oder Druckvorgänge in elektrische Energie umgewandelt werden als auch kontinuierlich und sich dynamisch verändernde Schwingung in elektrische Energie umgewandelt werden können.

Die Aufgabe wird nach den Merkmalen der unabhängigen Ansprüchen 1 und 7 gelöst.

Weiterbildungen der Erfindung ergeben sich aus den Unteransprüchen.

### I. Vorrichtungsmerkmale

Die Vorrichtung zur Umwandlung mechanischer Energie in elektrische Energie umfasst mindestens ein elektrovolumetrisches Wandlerelement, eine schwingfähige Masse, und mindestens ein Übertragungselement zur Übertragung von Schwingungen. Dabei ist das Wandlerelement so am Übertragungselement befestigt, dass eine Schwingung der Masse mindestens teilwise in eine Volumenänderung des Wandlerelements mittels des Übertragungselements unter Erzeugung einer elektrischen Spannung übertragbar ist. Die sich daraus ergebende Wechselspannung ist an Anschlussdrähten des elektrovolumetrischen Wandlerelements abgreifbar.

Das Übertragungselement kann dabei als elastisches Element ausgebildet sein, insbesondere als Federelement das hebelförmig oder in Form eines Biegebalkens geformt ist. Das Übertragungselement kann allerdings auch in Form einer Vorrichtung, welche mittels einer Fluide Schwingungen überträgt, ausgebildet sein. Es kann einseitig in einer Halterung eingespannt und / oder an einem freischwingenden Teilbereich mechanisch mit einer schwingfähigen Masse kontaktierbar sein. Der "freischwingende Teilbereich" kann allgemein als Bereich des Übertragungselement verstanden werden, der nicht fest eingespannt oder eingesetzt ist sondern mit einer schwingfähigen Masse in Kontakt gebracht werden kann oder mit dieser Masse in Verbindung steht.

Die schwingfähige Masse kann auch zumindest Teil des Übertragungselements selbst sein. Hier würde also das Übertragungselement die Rolle einer schwingfähigen Masse und die eines Übertragungselements übernehmen.

Speziell ist es auch möglich, dass Übertragungselement und die schwingfähigen Masse als ein Masse-Federsystem zusammenzufassen. Unter dem Begriff "Masse-Federystem" wird ein System verstanden, bei dem eine Masse mit einer Feder derart in mechanischer Verbindung gebracht werden kann, dass Schwingungen der Masse in Schwingungen der Feder übertragbar sind.

Das elektrovolumetrische Wandlerelement wandelt eine Verformung, z.B. eine Dehnung, in ein elektrisches Signal um. Es kann allgemein als piezoelektrisches Element, Piezokeramik und / oder Piezostack ausgebildet sein, welche jeweils eine Verformung in eine elektrische Energie umsetzen, wie z. B. ein elektro- oder magnetostriktives Element. Das Wandlerelement ist vorzugsweise ein keramischer Wandler, welcher aus mehreren, durch leitfähige Zwischenlagen getrennten Schichten besteht. Es können auch andere Ausführungsformen oder Materialien, wie monolithische Piezokeramiken oder piezoelektrische Polymere ausgewählt werden.

Die Verformung des elektrovolumetrischen Wandlerelements kann sowohl eine Zug- oder Ausdehnung in Abhängigkeit der Schwingung eines mit dem Wandlerelement verbundenden Übertragunselements, Feder oder elastischen Biegeelements sein.

Das Wandlerelement wird vorzugsweise von einer Halterung gehalten, insbesondere derart, dass eine Schwingung der Masse über das Übertragunselement zum elektrovolumetrischen Wandlerelement zumindest teilweise übertragbar ist, und durch die Schwingung das elektrovolumetrische Wandlerelement unter Erzeugung einer elektrischen Spannung verformbar ist.

Das Wandlerelement wird nach Anspruch 1 derart betrieben, dass es insbesondere durch ein zweites elastisches Element oder Übertragungselement druckvorgespannt ist.

Die Halterung kann als Gehäuse ausgebildet sein, welche auf der einen Seite offen ist. Durch diese Öffnung wird der freie Zugang bzw. die Kontaktierbarkeit für das freie Ende des elastischen Biegeelements zur schwingfähigen Masse gewährleistet. Die Halterung kann dabei aus mehreren, getrennten Teilen bestehen, d.h., sie muß nicht zwingend eine einheitliche Form annehmen oder einstückig sein.

Die Schwingungsübertragung an das elektrovolumetrische Wandlerelement wird nach Anspruch 1 durch den Einsatz eines zweiten elastischen Elements, z.B. einer Feder, ergänzt. Damit ist das Wandlerelement auch druckvorgespannt, insbesondere durch eine zweite Feder, die zwischen der Halterung und der dem elektrovolumetrischen Wandlerelement abgewandten Seite des elastischen Biegeelements eingepasst ist. Es wird eine kompakte Bauweise bevorzugt, bei der zumindest ein Teil des elastischen Biegeelements zwischen der zweiten Feder und dem piezoelektrischen Element eingeklemmt ist, dabei aber das eine Ende des elastischen Biegeelements mit der Halterung eingespannt und das andere Ende freischwingend bzw. mit einer schwingfähigen Masse kontaktierbar bleibt.

Die Vorrichtung läßt sich auch ohne Weiteres dadurch erweitern, dass mehrere elektrovolumetrische Wandlerelemente und Übertragungselemente zusammen eingesetzt werden. Dabei könnten mehrere elastische Biegeelemente wie bereits erläutert an deren freien Enden mit einer schwingfähigen Masse kontaktierbar sein.

### II. Verfahrensmerkmale

Beim Verfahren zur Umwandlung von mechanischer Energie in elektrische Energie wird eines der beschriebenen Vorrichtungen derart eingesetzt, dass eine Bewegung einer Masse über ein Übertragungselement an ein elektrovolumetrische Wandlerelement übertragen wird welches die Bewegungen in eine Spannung und mögliche Schwingungen der Masse in Wechselspannungen umwandelt.

Die Bewegung der Masse kann durch Schwingungen gekennzeichnet sein, welche von dem Übertragunselement, beispielsweise elastischen Biegeelement, aufgenommen und an das piezoelektrische Element übertragen werden. Die Bewegung der Masse kann auch über das elastische Biegelement an eine zweite Feder und an das Wandlerelement derart übertragen werden, dass das elastische Biegeelement und die zweite Feder eine Schwingung, insbesondere eine Resonanz auswirken, die an das Wandlerelement übertragen wird.

Die mechanischen Anregungen welche an das piezoelektrische Element übertragen werden, können grundsätzlich dadurch zustande kommen, dass das elastische Biegeelement und / oder die zweite Feder kurzzeitig gespannt und dann losgelassen werden. Dies führt zu einem Ausschwingen des Masse-Federsystems in Form einer gedämpften Schwingung mit exponentiell abklingender Schwingungsamplitude. Die erzeugte elektrische Wechselspannung weist einen ähnlichen, zeitlich exponentiell abklingenden Verlauf auf.

Beispiele mechanischer Anregungen welche in der Erfindung zum Einsatz kommen wären ein manueller Knopfdruck, oder das Überschreiten eines Gewichts.

Es ergibt sich bei der Erfindung insgesamt der Vorteil, dass die mechanische Anregung sowohl durch einzelne als auch durch mehrere Stöße oder durch Schwingungen erfolgt, denen die gesamte Wandlerkonstruktion ausgesetzt ist. In diesem Fall führt die träge Masse eines wie bereits ausgeführten Masse-Federsystems zu einer Energieübertragung auf ein piezoelektrische Element, das wiederum eine Wechselspannung abgibt, deren Verlauf von der Art und Dauer der Anregung abhängig ist.

Die Erfindung gestattet, daß die Federkonstanten, die Schwingungsmasse sowie die Dämpfung des Systems so dimensioniert werden, daß eine optimale Anpassung an die jeweiligen Erfordernisse der Stromerzeugung aus mechanischer Energie erreicht wird.

Im folgenden Ausführungsbeispiel wird die Erfindung schematisch näher erläutert.

### III. Ausführungsbeispiel

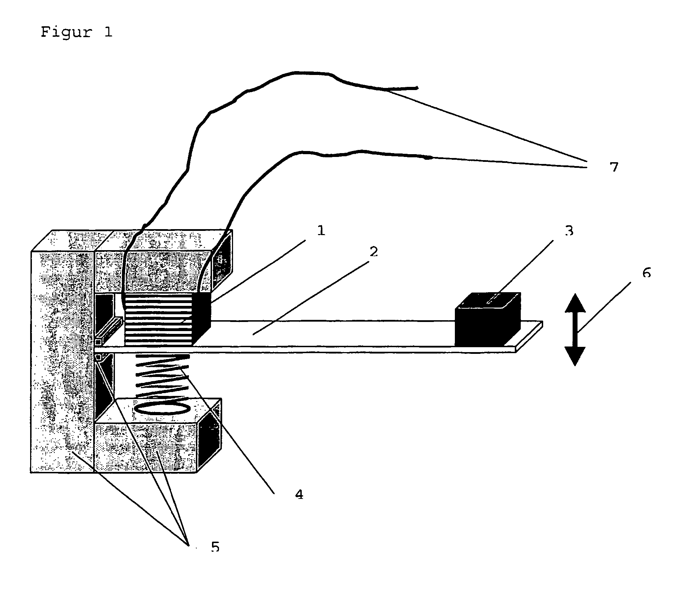

In **Figur 1** wird ein Ausführungsbeispiel der Erfindung gezeigt, bei dem in einer U-förmigen Halterung (5) ein piezoelektrisches Element (1), ein elastische Biegeelement(2) und eine Spiralfeder (4) gezeigt sind. Das elastische Biegeelement (2) gerät bei kurzzeitiger Auslenkung der Masse (3) in eine der Richtungen (6) in Schwingungen, wodurch periodisch Energie auf die Feder (4) und auf das piezoelektrische Element (1) übertragen wird. Das Biegeelement (2) ist vorzugweise an einem Ende mit dem Wandler derart befestigt, dass das mit der Halterung verbundene Ende des Biegeelements (2) zwischen zwei balkenförmige Ausprägungen der Halterung (5) eingesetzt ist und somit an diesem Ende festgeklemmt ist. Die aus den mechanischen Schwingungen resultierende Wechselspannung kann an den Drähten (7) abgenommen werden.

### IV. Anwendungsbeispiele

Die durch die mechanische Schwingungen gewonnene Spannung am piezoelektrischen Element kann grundsätzlich nach einer Gleichrichtung direkt zur Versorgung elektrischer Verbraucher eingesetzt werden, oder zum Laden von Energiespeichern wie Kondensatoren oder elektrochemischen Energiespeichern dienen.

Die Erfindung kann in miniaturisierten Bauweise ausgeführt werden und so optimal auf einer Radfelge eines Kraftfahrzeugs oder auf der Achse von Schienenfahrzeugen oder auf vibrierenden Maschinen eingesetzt werden. Die immer wieder auftretenden Erschütterungen oder Vibrationen führen jeweils oder permanent zu einer Schwingungsanregung des Feder-Massesystems und somit zur Verfügbarkeit einer elektrischen Wechselspannung am piezoelektrischen Element.

## Patentansprüche

1. Vorrichtung zur Umwandlung mechanischer Energie in elektrische Energie, welches
- ein elektrovolumetrisches Wandlerelement (1)
- eine schwingfähige Masse (3)
- mindestens ein Übertragungselement (2) zur Übertragung von Schwingungen aufweist,
wobei das Wandlerelement (1) so am Übertragungselement (2) befestigt ist , dass eine Schwingung der Masse (3) mindestens teilwise in eine Volumenänderung des Wandlerelements (1) unter Erzeugung einer elektrischen Spannung übertragbar ist,
**dadurch gekennzeichnet,**
**dass** das Wandlerelement (1), insbesondere durch ein zweites elastisches Element (4) druckvorgespannt ist.

2. Vorrichtung nach Anspruch 1, bei der das Übertragungselement ein zweites elastisches Element, insbesondere ein Federelement ist.

3. Vorrichtung nach einem der Anspruch 2, bei der das Übertragungselement (2) hebelförmig ausgebildet ist, insbesondere in Form eines Biegebalkens.

4. Vorrichtung nach einem der Ansprüche 1 bis 3, bei der die Masse (3) zumindest Teil des Übertragungselements (2) ist.

5. Vorrichtung nach einem der Ansprüch 1 bis 4, bei der das Wandlerelement (1) von einer Halterung (5) gehalten wird.

6. Vorrichtung nach einem der Ansprüche 1 bis 5, bei der das elektrovolumetrische Wandlerelement (1) ein piezoeelektrisches Element oder ein magnetostriktives Element ist.

7. Verfahren zur Umwandlung von mechanischer Energie in elektrische Energie, bei dem eine der Vorrichtungen nach den Ansprüchen 1 bis 6 derart eingesetzt wird, dass ein elektrovolumetrisches Wandlerelement druckvorgespannt wird und eine Bewegung einer Masse (3) über ein Übertragungselement (2) an das elektrovolumetrisches Wandlerelement (1) übertragen wird welches die Bewegungen (6) in Spannungen umwandelt.

8. Verfahren nach Anspruch 7, bei dem die Bewegung der Masse (3) eine Schwingung ist welche von dem Übertragungselement (2) aufgenommen wird und diese Schwingung an das elektrovolumetrische Element (1) übertragen wird.

9. Verfahren nach einem der Ansprüche 7 oder 8, bei dem die Bewegung der Masse (3) über das Übertragungselement (2) an eine zweites Übertragungselement (4) und an das elektrovolumetrische Wandlerelement (1) übertragen wird und das Übertragungselement (2) und die zweite Übertragungselement (4) zusammen eine Schwingung, auswirken, welche an das elektromechnanische Wandlerelement (1) übertragen wird.

## Claims

1. An apparatus for converting mechanical energy into electrical energy, having
- an electrovolumetric transducer element (1)
- a mass (3) that can oscillate
- at least one transmission element (2) for transmitting oscillations,
wherein the transducer element (1) is attached at the transmission element (2) such that an oscillation of the mass (3) can be transmitted at least partially into a volume change of the transducer element (1) while generating an electrical voltage,
**characterized in that,**
the transducer element (1) is pretensioned in compression, in particular, by a second elastic element (4).

2. The apparatus according to Claim 1, in which the transmission element is a second elastic element, in particular a spring element.

3. The apparatus according to Claim 2, in which the transmission element (2) is lever shaped, in particular in the shape of a bending beam.

4. The apparatus according to any one of the Claims 1 to 3, in which the mass (3) is at least part of the transmission element (2).

5. The apparatus according to one of the Claims 1 to 4, in which the transducer element (1) is held by a fixture (5) .

6. The apparatus according to one of the Claims 1 to 5, in which the electrovolumetric transducer element (1) is a piezoelectric element or a magnetostrictive element.

7. A method for converting mechanical energy into electrical energy, in which one of the devices according to the Claims 1 to 6 is used such that an electrovolumetric transducer element is pretensioned in compression, and a movement of a mass (3) is transmitted via a transmission element (2) to the electrovolumetric transducer element (1), converting the movements (6) into voltage.

8. The method according to Claim 7, in which the movement of the mass (3) is an oscillation picked up by the transmission element (2), and said oscillation is transmitted to the electrovolumetric element (1).

9. The method according to one of the Claims 7 or 8, in which the movement of the mass (3) is transmitted via the transmission element (2) to a second transmission element (4) and to the electrovolumetric transducer element (1), and the transmission element (2) and the second transmission element (4) together effect an oscillation, which is transmitted to the electromechanical transducer element (1).

## Revendications

1. Dispositif pour transformer de l'énergie mécanique en énergie électrique, lequel comporte
- un élément transducteur électrovolumétrique (1),
- une masse (3) capable d'osciller,
- au moins un élément de transmission (2) pour la transmission d'oscillations,
sachant que l'élément transducteur (1) est fixé à l'élément de transmission (2) de telle manière qu'une oscillation de la masse (3) soit au moins partiellement transmissible à une variation de volume de l'élément transducteur (1) et génère une tension électrique,
**caractérisé en ce que**
l'élément transducteur (1) est précomprimé particulièrement par un second élément élastique (4).

2. Dispositif selon la revendication 1, dans lequel l'élément de transmission est un second élément élastique, particulièrement un élément de ressort.

3. Dispositif selon la revendication 2, dans lequel l'élément de transmission (2) se présente sous une forme en levier, particulièrement en poutre flexionnelle.

4. Dispositif selon l'une quelconque des revendications 1 à 3, dans lequel la masse (3) est au moins une partie de l'élément de transmission (2).

5. Dispositif selon l'une quelconque des revendications 1 à 4, dans lequel l'élément transducteur (1) est fixé par une attache (5).

6. Dispositif selon l'une quelconque des revendications 1 à 5, dans lequel l'élément transducteur électrovolumétrique (1) est un élément piézoélectrique ou un élément magnétostrictif.

7. Procédé pour la transformation d'énergie mécanique en énergie électrique, dans lequel l'un des dispositifs selon les revendications 1 à 6 est utilisé de telle manière qu'un élément transducteur électrovolumétrique soit précomprimé et qu'un mouvement d'une masse (3) soit transmis par un élément de transmission (2) à l'élément transducteur électrovolumétrique (1), lequel transforme les mouvements (6) en tensions.

8. Procédé selon la revendication 7, dans lequel le mouvement de la masse (3) est une oscillation, laquelle est captée par l'élément de transmission (2), lequel transmet cette oscillation à l'élément électrovolumétrique (1).

9. Procédé selon l'une quelconque des revendications 7 ou 8, dans lequel le mouvement de la masse (3) est transmis par l'élément de transmission (2) à un second élément de transmission (4) et à l'élément transducteur électrovolumétrique (1), et l'élément de transmission (2) et le second élément de transmission (4) génèrent ensemble une oscillation, laquelle est transmise à l'élément transducteur électromécanique (1).
